(19) Europäisches Patentamt
European Patent Office
Office européen des brevets

(11) Veröffentlichungsnummer : **0 116 297**
**B1**

(12) **EUROPÄISCHE PATENTSCHRIFT**

(45) Veröffentlichungstag der Patentschrift : **02.12.87**

(51) Int. Cl.⁴ : **H 05 K 1/00**, B 32 B 15/08, C 08 G 73/10

(21) Anmeldenummer : **84100286.8**

(22) Anmeldetag : **12.01.84**

(54) **Polyimid-Laminate mit hoher Schälfestigkeit und Verfahren zu deren Herstellung.**

(30) Priorität : **15.01.83 DE 3301197**
**21.09.83 US 534223**

(43) Veröffentlichungstag der Anmeldung : **22.08.84 Patentblatt 84/34**

(45) Bekanntmachung des Hinweises auf die Patenterteilung : **02.12.87 Patentblatt 87/49**

(84) Benannte Vertragsstaaten : **BE CH DE FR GB IT LI NL**

(56) Entgegenhaltungen : **DE-B- 1 202 981**

(73) Patentinhaber : **Akzo GmbH**
**Postfach 10 01 49 Kasinostrasse 19-23**
**D-5600 Wuppertal-1 (DE)**

(72) Erfinder : **Zengel, Hans, Dr. Dipl.-Ing.**
**Nordring 6**
**D-8751 Kleinwallstadt (DE)**
Erfinder : **Klostermeier, Werner, Dr. Dipl.-Chem.**
**Spessartstrasse 29**
**D-8763 Klingenberg 2 (DE)**
Erfinder : **Meyer, Gerhard, Dr. Dipl.-Chem.**
**Blumenstrasse 26**
**D-8753 Obernburg (DE)**
Erfinder : **Lasher, Jeffery Drake**
**20 Alfred Drive**
**Tolland Connecticut 06084 (US)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft flexibles Laminat bestehend aus einer nicht mehr formbaren Schicht aus einem vollaromatischen Polyimid und einem Trägermaterial und ein Verfahren zu seiner Herstellung.

Polyimide erhält man unter anderem durch Reaktion aus Polyamidsäure. Die Herstellung der Polyamidcarbonsäuren, üblicherweise als Polyamidsäuren bezeichnet, ist bekannt. Hierzu kann auf die US-Patentschrift 3 981 847 und J. Poly. Sci., Teil A, Band III, Seiten 1373-1390 (1965) verwiesen werden. Unter Einwirkung von Hitze oder Dehydratisierungsmitteln lassen sich Polyamidsäuren durch eine Cyclisierungsreaktion zu extrem hitzebeständigen, sehr gut elektrisch isolierenden Polyimiden aushärten. Da Polyimide mit hoher Hitzebeständigkeit nicht mehr formbar sind, müssen sie als Polyamidsäure in die gewünschte Form des Endproduktes gebracht und danach der Cyclisierungsreaktion unterworfen werden.

Die Herstellung der Polyamidsäuren ist bekannt. Beispielsweise erhält man sie durch Umsetzung eines Tetracarbonsäuredianhydrids mit einem primären Diamin bei Temperaturen unter ca. 80 °C in einem wasserfreien polaren organischen Lösungsmittel, vorzugsweise einem aprotischen Lösungsmittel, wie sie zum Beispiel in dem genannten US-Patent 3 981 847 erwähnt sind. Auch die dort genannten aromatischen Tetracarbonsäuren und Tetracarbonsäuredianhydride sowie aromatischen Diamine entsprechen denen, die auch in der vorliegenden Erfindung von besonderer Bedeutung sind.

In den US-Patentschriften 3 179 614 und 3 179 634 werden Verfahren zur Herstellung von Polyamidsäuren bzw. deren Umsetzung zu den Polyimiden beschrieben. In diesen älteren Druckschriften werden verschiedene Verfahren zur Beschichtung von Substraten mit Polyamidsäure und nachfolgender Aushärtung zu Polyimidfolien beschrieben, z. Beispiel mittels Sprüh- oder Tauchverfahren mit nachfolgender mehrtägiger Aushärtung an der Luft bei Raumtemperatur. Mit Hilfe dieser Verfahren wurden Folien mit einer Dicke bis zu ca. 25 µm hergestellt. Dickere Folien oder Beschichtungen erforderten eine mehrfache Beschichtung und Umsetzung. Als nachteilig hat sich bei der mehrfachen Beschichtung von Flächengebilden (im Gegensatz zu Drähten) als Substrat erwiesen, daß die Haftung zwischen den Polyimidschichten äußerst gering ist, so daß sich diese leicht voneinander lösen. Polyimidfolien erhielt man auch durch Aufgießen von Polyamidsäurelösungen auf Glasplatten, Trocknen im Vakuum bei 50 bis 80 °C und Umsetzung der Polyamidsäurefolien zu den entsprechenden Polyimiden durch 30-minütiges Erhitzen auf 300 °C.

Die europäische Patentanmeldung 36 330 beschreibt ein Verfahren zur kontinuierlichen Herstellung einer in Phenol oder einem phenolartigen Lösungsmittel, zum Beispiel monohalogeniertem Phenol oder Kresol, löslichen Folie aus aromatischen Polyimid. Die europäische Patentanmeldung 48 221 bezieht sich, wie es dort heißt, auf mit einer Folie aus Polyamid, Polyamid-imid oder Polyimid versehene flexible Folienträgermaterialien, wobei die Folie an dem Trägermaterial ohne eine verklebende Zwischenschicht haften soll. Offenbart werden jedoch in dieser Schrift nur Herstellungsverfahren, die von löslichen und in ihrer endgültigen polymerisierten Form aus einer Lösung aufgebrachten aromatischen Polyimiden ausgehen.

Was die unlöslichen Polyimide betrifft, so findet sich in der europäischen Patentanmeldung 48 221 kein konkreter Hinweis auf die für die Aushärtung von Polyamidsäuren zu Polyimiden in situ erforderlichen Bedingungen. Die erzielte Haftung der Folien entspricht der aus dem bekannten Stand der Technik, beispielsweise den im US-Patent 3 179 614, Beispiel 26 erhaltenen Werten. Eine Überprüfung ergab, daß die Schälfestigkeiten unter 1,7 N/cm liegen.

Mit dem in der europäischen Patentanmeldung 48 221 beschriebenen Verfahren war es bisher nicht möglich, eine Polyimidschicht von ausreichender Dicke, das heißt über ca. 25 µm durch ein kontinuierliches Extrusionsverfahren zu erhalten, bei dem eine direkte Aufbringung auf ein endgültiges Substrat, z. Beispiel Kupferfolie, erfolgt und ein Laminat erhalten wird, dessen Schälfestigkeit und elektrische Eigenschaften, z. Beispiel dielektrischer Verlustfaktor, Durchschlagsfestigkeit, Widerstand und Isolationseigenschaften, den kommerziellen Anforderungen an flexible, gedruckte Schaltkreise entsprechen, bei denen diese Laminate zum Einsatz gelangen. Bei den nicht mehr formbaren Typen von Polyimiden war es bisher üblich, aus dem Vorprodukt Polyamidsäure eine Folie ohne zusätzliches Substrat herzustellen, die Folie auszuhärten und anschließend die Polyimidfolie und ein Kupferträgermaterial mit einer Verklebungszwischenschicht zu einem Laminat zu verarbeiten oder die reine Polyimidfolie mit einer Kupferschicht, z. Beispiel durch Aufdampfen zu versehen. Ein solches Verfahren erfordert natürlich einen erheblichen Mehraufwand durch zusätzliche Arbeitsgänge sowie den Einsatz von Klebstoffen für die Laminierung. Außerdem hat das Laminat den technischen Nachteil, daß die handelsüblichen Klebstoffe nicht so hohe Temperaturen überstehen wie die Polyimidfolie, so daß Anwendungen, bei denen diese höheren Temperaturen benötigt werden, z. Beispiel beim Verlöten oder Verschweißen von Verbindungen, damit ausgeschlossen blieben. Bei den im Laminat beim Löten erreichten Temperaturen wird der Klebstoff weich oder schmilzt und die Polyimidfolie schwimmt oder schwebt in dem geschmolzenen Klebstoff auf der Kupferoberfläche.

Um diesen Schwierigkeiten mit Klebstoffen zu entgehen, wäre ein Verfahren wünschenswert, bei dem eine Polyimidlösung unmittelbar auf das endgültige Substrat extrudiert und danach das Lösungsmittel entfernt würde, so daß eine feste Verbindung zwischen der Polyimidfolie und dem Substrat entstünde.

Da die Lösungsmittel für die Polyamidsäure bzw. deren Herstellung und das Polyimid nicht die gleichen sind, wäre ein solches Verfahren nur mit einer großen Anzahl von Stufen vorstellbar. Deshalb können die in phenolischen Lösungsmitteln unlöslichen Polyimide nicht in der gleichen Weise wie die phenollöslichen Polyimide der erwähnten europäischen Patentanmeldung 36 330 unmittelbar auf das Substrat extrudiert werden. Andererseits sind die in phenolartigen Lösungsmitteln unlöslichen Polyimide den dort löslichen bezüglich thermischer Stabilität weit überlegen.

Bei früheren Versuchen, das Substrat mit Polyamidsäurelösungen zu beschichten und die Polyamidsäure zu einem Polyimid auszuhärten, bildeten sich Blasen in der Folie, was auf das Zusammenwirken einer raschen Verflüchtigung des Lösungsmittels und der Bildung von Wasser durch die Imidisierung im Inneren der Beschichtung und Bildung einer Polyimidhaut mit Lösungsmittel- und Wassereinschlüssen in der Folienmatrix zurückzuführen ist. Die auf diese Weise in der Polyimidschicht entstandenen Unterbrechungen verschlechtern die elektrischen Eigenschaften, die für den Einsatz der Polyimid-Laminate in gedruckten Schaltkreisen erforderlich sind. Sie beeinträchtigen die mechanischen Eigenschaften wie Zugfestigkeit und Bruchdehnung der Folie und verringern die Festigkeit der Verbindung zwischen der Polyimidfolie und dem Substrat. Auch kann sich aufgrund einer zu schnellen Aushärtung der Polyamidsäure an der Oberfläche eine Polyimidoberflächenschicht oder Haut bilden, was wiederum Freisetzung von flüchtigen Stoffen (Lösungsmittel und Feuchtigkeit) durch Diffundieren an die Oberfläche verhindert. Damit kann es zu einer Ansammlung von flüchtigen Molekülen und der Bildung von Hohlräumen in dern Polyimidschicht kommen. Darüberhinaus weist dieses Verfahren den Nachteil auf, daß bei der Herstellung dicker Filme wegen der nicht vollständigen Entfernung des Lösungsmittels vor dem Aushärteschritt nur brüchige mit Unterbrechungen versehene niedrig-molekulare Polyimidfilme erhalten werden.

In der US-PS 3 428 602 wird das Problem der Blasenbildung angesprochen, das beim Aufgießen von dickeren Bahnen von Polyimidmaterial in Form von Folien auf eine Polytetrafluoräthylen-Trägerfolie auftritt. Es wird vorgeschlagen, das Lösungsmittel aus der Polyamidsäurelösung bei einer unter der Hitzehärtetemperatur der Polyamidsäure liegenden Temperatur zu entfernen, da die gleichzeitige Entfernung des Lösungsmittels und die Umsetzung der Säure zu Polyimid zu der festgestellten Blasenbildung führt. Ferner wird dort festgestellt, daß nach Verringerung der Lösungsmittelmenge auf ca. 50 % durch Fortsetzung des Hitzetrocknungsvorganges allein eine weitere Verringerung des Lösungsmittelgehaltes nicht möglich ist. Gemäß der Lehre dieser Patentschrift wird zunächst eine Polyamidsäurelösung mit niedrigem Feststoffgehalt (12 bis 15 Vol.-%) zu einem dünnen Film gegossen und bei Temperaturen unterhalb der Hitzehärtungstemperatur der Polyamidsäure zwecks Verringerung des Lösungsmittelgehaltes auf ca. 50 % getrocknet, worauf die konzentrierte Polyamidsäurelösung einem Scherprozeß, z. Beispiel mittels dort beschriebener Gummiwalzen unterzogen wird und weiterer Trockung bei Temperaturen von ca. 65 °C bis zu ca. 110 °C unterzogen wird, wodurch die Konzentration der Polyamidsäure auf ca. 75 % erhöht wird. Die konzentrierte Polyamidsäurelösung wird dann zu einem dicken Film geformt, indem man ihn beispielsweise durch Quetschwalzen laufen läßt. Dann wird der Film in einem Aushärtungsofen auf Temperaturen zwischen 150 °C und ca. 370 °C erhitzt. Bei diesem Verfahren war es notwendig, die Polyamidsäure dem Scherprozeß mittels der Gummiwalzen auszusetzen, um eine ausreichende Oberfläche zu erhalten, welche die zusätzliche Trocknung der Polyamidsäurelösung vor dem Aushärten gewährleistet. Im übrigen bezieht sich diese US-Patentschrift auf die Bildung von trägerloser Folie mit einer Dicke von über 250 µm, jedoch nicht auf die direkte Extrusion auf ein Substrat, das mit der für die Fertigprodukte erforderlichen Festigkeit an der Folie haftet, ohne daß hierfür eine verklebende Zwischenschicht erforderlich ist. Die deutsche Auslegeschrift 12 02 981 offenbart ein Verfahren zur Herstellung von Polyimidformkörpern, wobei man die Temperatur während der Umsetzung der Polyamidsäure zu Polyimid allmählich erhöht. In Beispiel 16 wird eine pigmentierte Polyamidsäure auf ein Kupferträgermaterial aufgebracht und durch Erhitzen zu einem unlöslichen Polyimid umgesetzt, wobei die Folie in einen Ofen von 100 °C eingeführt und die Temperatur innerhalb von 35 Minuten allmählich auf 370 °C erhöht wird. Die Haftungseigenschaften der Folien wurden mit gut bezeichnet. Bei einer Überprüfung wurde jedoch festgestellt, daß die Schälfestigkeit unter 1,7 N/cm liegt. Neben der geringen Schälfestigkeit war diese Folie auch nicht blasenfrei, wenn die Dicke mehr als 10 µm betrug. Wie aus Beispiel 17 der deutschen Auslegeschrift 12 02 981 hervorgeht, sind zum Beispiel zehn einzelne Schichten erforderlich, um eine Beschichtungsdicke von 0,023 mm bzw. 0,002 3 mm pro Schicht bei einem Draht von 25 gauge zu erhalten.

Aufgabe der vorliegenden Erfindung war die Schaffung eines flexiblen Laminates, ggf. großer Schichtdicke, aus einem vollaromatischen Polyimid und einem Trägermaterial, das ohne klebende Zwischenschicht eine hohe Schälfestigkeit, gute elektrische und mechanische Eigenschaften aufweist, wobei die Haftung zwischen Trägerschicht und Polyimidschicht hohen Temperaturen standhält und das in einem technisch einfach zu steuernden Verfahren herstellbar ist.

Gelöst wird diese Aufgabe durch ein Laminat und ein Verfahren zu seiner Herstellung. Das Laminat ist dadurch gekennzeichnet, daß die Polyimidschicht direkt an dem Trägermaterial mit einer Schälfestigkeit von mindestens 4,0 N/cm haftet, wobei das Polyimid in phenolischen Lösungsmitteln unlöslich ist und die Polyimidschicht eine Zugfestigkeit von 100 bis 150 N pro $mm^2$, eine Zugdehnung von 15 bis 100 % und einen dielektrischen Verlustfaktor von $1{,}5 \times 10^{-3}$ bis $5 \times 10^{-3}$ bei 1 KHz aufweist. Vorzugsweise beträgt die Schichtdicke der Polyimidschicht 10 µm bis 1 mm. In weiterer bevorzugter Ausführungsform beträgt die Dicke der Polyimidschicht 50 bis 250 µm und sofern das Trägermaterial aus

Fasern, Metalldrähten oder Kabeln besteht, wird eine Dicke von 30 bis 250 µm bevorzugt. Das erfindungsgemäße Verfahren besteht darin, daß man eine aromatische Tetracarbonsäure oder deren Dianhydrid mit einem primären aromatischen Diamin im Molverhältnis 0,95 : 1 bis 1,05 : 1 in einem polaren Lösungsmittel zu einer Polymerverbindung aus einer Polyamidsäure mit einer reduzierten Viskosität von mindestens 0,5 umsetzt, die Polyamidsäurelösung auf ein Trägermaterial aufbringt, das Lösungsmittel in situ in einer ersten Stufe bei 100-200° entfernt, und den Film in einer zweiten Stufe bei mehr als 200 °C, vorzugsweise mehr als 300 °C, in situ zu einem nicht mehr formbaren Polyimid aushärtet, das in phenolischen Lösungsmitteln unlöslich ist, wobei mindestens 95 % der Polyamidsäure zu Polyimid umgesetzt werden. Unter vollaromatischen Polyimiden werden hierbei Polyimide verstanden, die aus Tetracarbonsäuren bzw. deren Dianhydriden und Diaminen erhalten werden, deren Carboxyl- bzw. primäre Aminogruppen direkt an einen aromatischen Ring gebunden sind.

Die Herstellung der Polyamidsäure erfolgt durch Umsetzung einer aromatischen Tetracarbonsäure, vorzugsweise Pyromellitsäure oder vorzugsweise ihres Dianhydrids, Pyromellitsäuredianhydrid (PMDA) mit einem primären aromatischen Diamin, bevorzugt ist 4,4'-Diaminodiphenyläther (DADE), in einem Lösungsmittel, zum Beispiel Dimethylacetamid (DMAc). Zum Polyimidlaminat gelangt man durch Aufbringen eines Films der Polyamidsäurelösung auf ein Trägermaterial, wie eine Metallfolie oder einen Metalldraht oder ein Polymermaterial und Aushärtung des Films in situ durch Hitzebehandlung in mindestens zwei Stufen, so daß man ein Laminat erhält, dessen Polyimidschicht fest an dem genannten Trägermaterial haftet, ohne daß für die Verbindung der Polyimidfolie mit dem Substrat der Einsatz einer verklebenden Zwischenschicht erforderlich ist.

Bei dem vorliegenden Laminat kann es sich um ein Flächengebilde, das heißt eine flexible Polyimidschicht handeln, die an einer Folie aus Kupfer oder einem anderen metallischen Material, zum Beispiel Aluminium, Nickel oder Stahl oder einer Legierung haftet, oder um eine endlose Beschichtung oder Beschichtung begrenzter Länge auf einem stab- oder röhrenförmigen Trägermaterial, zum Beispiel einem Draht oder einem Kabel handeln. In jedem Fall haftet die Polyimidschicht fest an dem Substrat und besitzt eine hohe Schälfestigkeit von 4,0 N/cm und mehr.

Als Trägermaterial können Werkstoffe aus metallischem Material oder aus synthetischen Polymeren dienen. Im Fall metallischer Werkstoffe muß es sich nicht um das Metall als Element in reiner Form handeln. Es können insbesondere auch Trägermaterialien aus Metallegierungen eingesetzt werden wie Legierungen, die Nickel, Chrom und Eisen oder Nickel und Kupfer enthalten. In manchen Fällen hat es sich als vorteilhaft erwiesen, das Trägermaterial vor der Beschichtung vorzubehandeln. Diese Vorbehandlung kann in einer chemischen Behandlung, z. B. Einwirkung einer sauren Salzlösung oder in einer mechanischen Aufrauhung bestehen. Es hat sich herausgestellt, daß sich durch diese Vorbehandlung eine weitere Erhöhung der Haftung der Polyimidschicht und damit eine Erhöhung der Schälfestigkeit erzielen läßt. Die chemische Vorbehandlung kann neben einer Aufrauhung der Oberfläche zur Ausbildung von Metalloxidgruppen an der zu beschichtenden Oberfläche des Trägermaterials führen, wodurch ggf. die Haftung eines metallischen Trägermaterials an der Polyimidschicht weiter erhöht werden kann. Als günstig hat es sich erwiesen, die Vorbehandlung so durchzuführen, daß ein Mittenrauhwert ($R_a$) von mindestens 0,2 µm erhalten wird.

Um zu den erfindungsgemäßen Laminaten zu gelangen, setzt man ein primäres aromatisches Diamin mit einer aromatischen Tetracarbonsäure oder ihrem Dianhydrid unter Bedingungen, die zur Bildung einer Lösung von Polyamidsäure in einem Lösungsmittel führen, um, in einer Ausführungsform der Erfindung in einem Extruder. Anschließend kann die Extrusion einer Schicht der Polyimidsäurelösung direkt auf das Substrat erfolgen, wobei das Lösungsmittel in situ zunächst in einer ersten Heizzone weitestgehend aus der Polyamidsäureschicht entfernt und die Polyamidsäureschicht dann in situ durch ein weitere Hitzebehandlung in mindestens einer zweiten Heizzone bei einer höheren, zu praktisch vollständiger Imidisierung führenden Temperatur ausgehärtet wird. Anstatt die Polyamidsäurelösung durch Extrudieren auf das Trägermaterial aufzubringen, kann sie auch durch Aufrakeln aufgebracht werden. Die anschließende Temperaturbehandlung, die zur Entfernung des Lösungsmittels und zur Bildung des Polyimids führt, ist die gleiche wie oben angegeben. Um eine Polyimidschicht von mehr als 10 µm zu erhalten, die keine Unterbrechungen oder Fehler aufgrund von Blasen enthält, die hervorgerufen sind durch Zusammenwirken eines Hauteffektes und einer zu raschen Verdampfung des Lösungsmittels oder des bei der Imidisierung oder Aushärtung entstehenden Wasserdampfes und die fest an dem Substrat haftet, ist eine besondere Folge von Hitzebehandlungen wesentlich, wie sie erfindungsgemäß vorgesehen ist.

Die bei der Erfindung vorwendeten, durch Umsetzung einer aromatischen Tetracarbonsäure oder ihres Dianhydrids mit einem primären aromatischen Diamin in einem polaren organischen Lösungsmittel erhaltenen Polyamidsäurevorprodukte besitzen folgende Strukturformel :

(Siehe Schema Seite 5 f.)

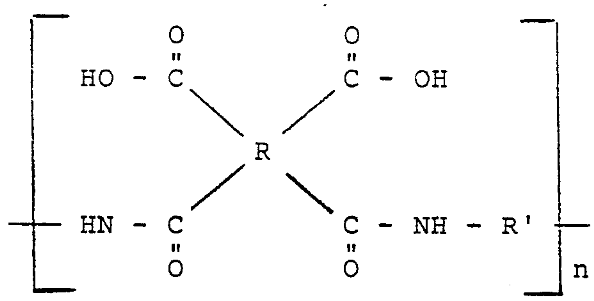

wobei

R einen aromatischen vierwertigen Rest und

R' einen zweiwertigen aromatischen Rest darstellen und

n ausreicht zur Bildung einer Polyamidsäure mit einer reduzierten Viskosität von 0,5 oder höher, gemessen als 0,5 %ige Lösung in 0,1 Mol/Liter Lithiumbromid enthaltendem Dimethylacetamid. Die Polyamidsäure wird nach dem Aufbringen auf das Substrat nach dem offenbarten Erhitzungsverfahren ausgehärtet, wobei ein nicht mehr formbares, in Phenol bzw. phenolartigen Lösungsmitteln unlösliches Polyimid mit der folgenden sich wiederholenden Struktur entsteht :

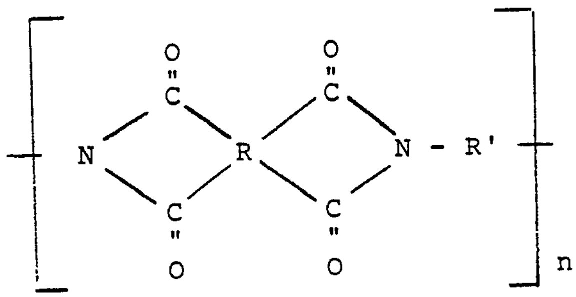

in der R und R' gleiche Reste darstellen, wie sie zuvor beschrieben worden sind.

Unter « nicht mehr formbar » im Sinne der Erfindung wird verstanden, daß diese Polyimide im Gegensatz zu anderen bekannten Polyimiden nicht unzersetzt schmelzbar und in herkömmlichen Lösungsmitteln unlöslich sind, so daß weder über Schmelzen noch Lösen eine neue Formgebung möglich ist.

Bei der Herstellung der Polyamidsäure werden als Ausgangsmaterialien vorzugsweise Pyromellitsäuredianhydrid und 4,4'-Diaminodiphenyläther und als Lösungsmittel vorzugsweise Dimethylacetamid verwendet.

Nach dem erfindungsgemäßen Verfahren können auch andere Reaktionspartner extrudiert werden, die in herkömmlichen phenolischen Lösungsmitteln, zum Beispiel Phenol oder substituierten Phenolen (halogenierten Phenolen), unlösliche, nicht mehr formbare Polyimide bilden. Zu den im Rahmen der vorliegenden Erfindung verwendbaren aromatischen Dianhydriden gehören Pyromellitsäuredianhydrid (PMDA) ; 2,3,6,7-Naphthalin-Tetracarbonsäure-Dianhydrid ; 3,3',4,4'-Tetracarboxy-Diphenylsulfon-Dianhydrid ; Perylen-3,4,9,10-Tetracarbonsäure-Dianhydrid ; 3,3',4,4'-Tetracarboxy-diphenyläther-dianhydrid.

Zu den im Rahmen der vorliegenden Erfindung verwendbaren aromatischen Diaminen gehören unter anderem 4,4'-Diamino-diphenyläther ; 5-Amino-2(p-Aminophenyl)-Benzothiazol ; 4-Amino-2-(p-Aminophenyl)-Benzothiazol : 5-Amino-2-(m-Aminophenyl)-Benzothiazol ; 5-Amino-2-(p-Aminophenyl)-Benzoxazol ; 4-Amino-2-(m-Aminophenyl)-Benzothiazol ; p- und m-Phenylen diamin ; 4,4'-Diamino-Diphenyl ; Bis-(4-Aminophenyl)-Methan ; 4-Amino-2-(p-Aminophenyl)-Benzoxazol ; 4-Amino-2-(m-aminophenyl)-benzoxazol ; 5-Amino-2-(m-Aminophenyl)-Benzoxazol : 2,5-Diamino-Benzoxazol : 2,5-Diamino-Benzothiazol.

Obwohl als Lösungsmittel vorzugsweise Dimethylacetamid (DMAc) verwendet wird, können auch andere polare organische Lösungsmittel, zum Beispiel N,N-Dimethyl-methoxyacetamid, Dimethylformamid (DMF) ; Diäthylformamid : N-Methyl-2-Pyrrolidon (NMP) und Dimethylsulfoxid (DMSO) eingesetzt werden. Als weitere Lösungsmittel können zum Beispiel N-Methylcaprolactam, Dimethylsulfon, Pyridin, Hexamethylphosphoramid, N-Acetyl-2-Pyrrolidon, Tetramethylharnstoff und Tetramethylensulfon verwendet werden.

Die Herstellung der Polyamidsäure kann gemäß dem Stand der Technik, wie er beispielsweise in den genannten US-Patentschriften 3 179 614 und 3 179 634 beschrieben ist, erfolgen.

In der Abbildung 1 wird eine bevorzugte Vorrichtung zur Durchführung des erfindungsgemäßen Verfahrens schematisch dargestellt. Abbildung 2 stellt den Querschnitt des Kondensations- bzw. Aushärtungsofens entlang der Linie 2-2 dar.

In der in Abbildung 1 dargestellten Vorrichtung wird aus dem Dianhydrid und dem Diamin eine trockene Mischung mit einem Molverhältnis PMDA : DADE zwischen 0,95 : 1 und 1,05 : 1 hergestellt.

Diese Mischung wird einer gravimetrischen Dosiervorrichtung 3 zugeführt. Dann wird die Mischung mit genau gesteuerter Geschwindigkeit in ein Extruder-Reaktionsgefäß 4 eingespeist. Mit Hilfe einer Dosierpumpe 5 wird der in dem Extruderreaktionsgefäß 4 befindlichen trockenen Mischung ein polares Lösungsmittel zugesetzt. Das Molekulargewicht der Polyamidsäure wird durch das Molverhältnis von Dianhydrid zu Diamin bestimmt. Den optimalen Molekulargewichtsbereich der Polyamidsäure erreicht man bei einem Molverhältnis zwischen 0,98 und 1,02 und er wird als reduzierte Viskosität ($\eta_{red}$) einer 0,5 %igen Lösung in 0,1 Mol/liter Lithiumbromid enthaltendem Dimethylacetamid gemessen. Die reduzierte Viskosität der Polyamidsäure beträgt bei molaren Verhältnissen von 0,95 und 1,05 PMDA : DADE etwa 0,5 und liegt beim optimalen Verhältnis (zwischen 0,98 bis 1,02 PMDA : DADE) zwischen ca. 1,0 und 4,0. Bei einem molaren Verhältnis von 0,95 wurde ein durchschnittliches Molekulargewicht der gebildeten Polyamidsäure von 32 000 gefunden, bei 1,0 ca. 200 000, bei 1,03 ca. 35 000 (Bestimmung mit einem FIKA-Lichtstreuungsphotometer, Modell PGD 42 000 bei $\lambda$ = 436 nm).

Die Temperatur im Extruderreaktionsgefäß 4 sollte auf einem Niveau unter ca. 80 °C gehalten werden : in der Praxis kann sie jedoch allmählich von ca. 20 °C ausgehend gesteigert oder in Zonen mit ansteigender Temperatur auf maximal 80 °C angehoben werden. Das Lösungsmittel wird in der ersten Zone des Extruderreaktionsgefäßes 4 zugesetzt. Die Verweilzeit im Extruderreaktionsgefäß 4 liegt im Bereich von 1 bis 5 Minuten.

Am Ende dieser Verweilzeit ist die Reaktion zur Bildung der Polyamidsäure abgeschlossen. Die Polyamidsäure mit einer reduzierten Viskosität von 0,5 bis 4,0, vorzugsweise mehr als 1,0 kann dann durch eine Schlitzdüse 6 auf ein Trägermaterial 7, bei dem es sich um ein von einer Spule oder Rolle 8 abgezogenes Blech aus Kupfer oder einem anderen Metall oder um eine synthetische Folie handeln kann, extrudiert werden.

Das mit der Polyamidsäurelösung beschichtete Substrat läuft dann 5 bis 20 Minuten oder länger zwecks Kondensation zum Polyimid durch einen Ofen 10, dem mittels einer Versorgungsleitung 11 Stickstoff zugespeist wird. Die Durchlaufzeit hängt von der Filmdicke ab, da bei erhöhter Dicke längere Zeiten erforderlich sind.

Es hat sich als wesentlich erwiesen, die Temperaturen in aufeinanderfolgenden Zonen im Ofen zu steuern ; wenn jedoch diese Steuerung innerhalb des genannten Bereiches erfolgt, bildet sich in sehr kurzer Zeit auf dem Substrat 7 eine nicht mehr formbare, blasenfreie Polyimidschicht mit ausgezeichneten elektrischen und mechanischen Eigenschaften, die an dem Substrat mit einer Schälfestigkeit von über 4,0 N/cm haftet. Ohne Beschränkung auf eine theoretische Erläuterung dieses überraschenden Ergebnisses ist anzunehmen, daß es erforderlich ist, daß das Lösungsmittel so langsam durch die Polyamidsäureschicht diffundiert und von der freiliegenden Folienoberfläche freigesetzt wird, daß sich keine Lösungsmittelblasen bilden können, die sich vergrößern und in der Polymerfolien-Matrix eingeschlossen bleiben. Auch muß ein Großteil des Lösungsmittels von der freiliegenden Seite der Polyamidsäurefolie freigesetzt werden, bevor die Imidisierung abgeschlossen ist. Ferner muß die Imidisierungsreaktion zu 80 bis 90 % bei Temperaturen unter ca. 180 °C abgeschlossen werden, so daß auch der größere Teil des bei der Cyclisierungsreaktion gebildeten Wassers an die Folienoberfläche diffundiert und freigesetzt wird.

Um das vorstehende Ziel zu erreichen, sind im der Kondensation dienenden Ofen mittels Widerstandselementen 12, 13, 14 und 15 folgende Heizzonen vorgesehen : In der ersten Zone wird die Temperatur mit einem elektrischen Widerstandselement 12 im Bereich von 100 bis 150 °C gehalten ; in der zweiten Zone wird die Temperatur auf ca. 130 °C bis ca. 200 °C, vorzugsweise unterhalb 180 °C angehoben ; in der dritten Zone wird die Temperatur auf ca. 200 bis 400 °C erhöht, nachdem im wesentlichen das gesamte Lösungsmittel zur Oberfläche diffundiert und entfernt und auch der größte Teil des bei der Cyclisierungsreaktion gebildeten Wassers entfernt ist ; in der vierten Zone wird die Temperatur nochmals, vorzugsweise auf ca. 300 bis 600 °C, angehoben. Jede dieser Zonen ist ungefähr gleich lang und daher ist auch die Verweilzeit in den einzelnen Zonen ungefähr gleich. Man kann jedoch die Laminatgeschwindigkeit und somit den Durchsatz erhöhen, indem man die erste und/oder zweite Zone verlängert oder der ersten Zone eine zusätzliche Heizzone vorschaltet, die man bei einer Temperatur von über 50 °C, jedoch unter der Temperatur der ersten Zone, hält. Bei der in Abbildung 2 gezeigten Vorrichtung kann der Ofen 10 mit beweglichem Deckel 16 versehen sein, um einen leichten Zugang zum Laminat im Ofen zu schaffen.

Die nachfolgenden Beispiele dienen der weiteren Veranschaulichung der Erfindung.

## Beispiel 1

In einem handelsüblichen Pulvermischer wurde eine trockene Mischung aus Pyromellitsäuredianhydrid (PMDA) und 4,4'-Diaminodiphenyläther (DADE) hergestellt. Insgesamt wurden 5,0 kg PMDA und 4,54 kg DADE (molares Verhältnis PMDA : DADE 1,01) in den Mischer eingewogen und danach 48 Stunden auf der höchsten Geschwindigkeitsstufe gemischt. Anschließend wurden ca. 1,6 kg der Mischung in eine gravimetrische Dosiervorrichtung gegeben, welche die Mischung mit einer Geschwindigkeit von ca. 200 Gramm pro Stunde einem Doppelschneckenextruder mit negativer Einspeisung (negative-feed extruder) zuführte. In der ersten Extruderstufe, die bei 20 °C gehalten wurde, wurde DMAc mit einer Geschwindigkeit von ca. 430 Gramm pro Stunde zugesetzt, so daß eine Feststoffkonzentration von 31,7 Gew.-%

erhalten wurde. Während der restlichen Verweilzeit im Extruder wurde die Temperatur in aufeinanderfolgenden Zonen auf 50 °C erhöht. Dabei bildete sich eine Polyamidsäure mit einer reduzierten Viskosität von 1,67, die aus dem Extruderzylinder durch eine Düse für dünne Folien gepreßt wurde. Die Düsenöffnung hatte einen rechteckigen Querschnitt mit den Maßen 200 × 0,35 mm. Der Druck am Düsenkopf betrug 85 bar. Die Polyamidsäurelösung wurde auf eine 35 µm dicke Bahn aus gewalzter getemperter Kupferfolie (Oak F-111) extrudiert und das Laminat wurde dann in einen Ofen mit vier gleichlangen Temperaturzonen von 140 °C, 180 °C, 350 °C und 400 °C unter einer Stickstoffatmosphäre eingeleitet. Die Gesamtverweilzeit des Laminats betrug 10 Minuten. Während dieser Zeit wurde die Polyamidsäure praktisch vollkommen in das Polyimid umgesetzt. Die Polyimidfolie haftete fest an dem Kupfersubstrat und war frei von Blasen und Unterbrechungen.

Bei der vorgenannten Oak F-111-Kupferfolie handelt es sich um ein Produkt der Firma Oak Materials Group Inc., USA das die Anforderungen der IPC-CF 150 E erfüllt.

Beispiel 2

Eine zweite 1,6-kg Probe der Mischung wurde der gleichen Behandlung wie im Beispiel 1 unterzogen, jedoch mit dem Unterschied, daß nunmehr eine 70 µm dicke Kupferfolie (Oak F-111) als Substrat diente. Der Polyimidfilm haftete fest an der Kupferfolie und war frei von Blasen und Unterbrechungen. Die Eigenschaften der Laminate aus den Beispielen 1 und 2 sind in der nachfolgenden Tabelle zusammengestellt.

(Siehe Tabelle Seite 8 f.)

Beispiel 3

Ein Dreihalskolben wird mit 8,17 g PMDA beschickt, dem 7,58 g DADE, gelöst in 60 g DMAc zugesetzt wird. Das DADE war vorher unter ständigem Rühren bei voller Geschwindigkeit in DMAc gelöst worden. Das Molverhältnis PMDA : DADE betrug 0,99 : 1,00. Danach wurden in das Reaktionsgefäß weitere 29,25 g des DMAc gegeben, das vorher zum Ausspülen des Kolbens verwendet wurde, in dem DADE gelöst wurde. Die Reaktion wird 80 Minuten unter Rühren bei einer Temperatur von 22 °C in einer Stickstoffatmosphäre fortgesetzt. Ein Teil der entstandenen Polyamidsäurelösung wird auf eine vorher mit einer Eisen-III-chloridlösung aus 30 g $FeCl_3$, 60 $cm^3$ 12 n HCl und 180 $cm^3$ Wasser geätzte Nickel-Chrom-Folie einer Dicke von 23 µm (Inconel der Fa. Somers Thin-Strip/Brass Group, Olin Corp. (Somers), Waterbury, Connecticut) aufgegossen. Die Inconel-Folie bestand aus einer Legierung mit Nickel als Hauptbestandteil sowie Chrom und Eisen. Die aufgegossene Polyamidsäurelösung wird auf eine Dicke von 356 µm mit Hilfe eines Glasstabes, auf den Kupferdraht mit einen Durchmesser von 356 µm gewickelt ist, ausgezogen. Die Legierungsfolie wird auf eine Glasplatte aufgebracht und mit einem Klebestreifen befestigt. Der Film wird 20 Minuten bei 70 °C getrocknet und dann in einem Vakuumtrockner bei einem Unterdruck von ca. 2 mm Hg bei 160 °C in einer Stickstoffatmosphäre behandelt. Die Temperatur des Trockners wird dann innerhalb von 4 1/2 Stunden auf 310 °C erhöht. Wenn der Film eine Temperatur von 160 °C erreicht hat, was innerhalb von ca. 1-2 Minuten der Fall ist, ist bereits der größte Teil des Lösungsmittels ausgetrieben, wie man an Hand der Farbe des Films, einem klaren, hellen Gelb, feststellen kann. Der ausgehärtete trockene Film besaß eine Dicke von 25 µm.

Eine gemäß Beispiel 1 erhaltene Polyamidsäure-Probe wird auf 22 Gew.-% Polyamidsäure und eine reduzierte Viskosität ($\eta_{red}$) von 1,22 mit DMAc verdünnt und auf eine Legierungsfolie von 58 µm Dicke aus einer Kupfer-Nickel-Legierung mit ca. 70 % Cu und ca. 30 % Ni (Cupro-Nickel 30 # 715 von Somers Thin-Strip/Brass Group, Olin Corp. (Somers), Waterbury, Connecticut) mit einer gerauhten (« machine scrubbed ») Oberfläche aufgegossen und mit einer Rakel bis zu einer Naßfoliendicke von 356 µm verstrichen. Der aufgegossene Film wird entsprechend obigem Beispiel getrocknet und ausgehärtet. Beide Filme besaßen eine extrem hohe Schälfestigkeit, während eine ähnliche Filmprobe, die sich auf einer glänzenden, unbehandelten Legierungsfolie befindet, sich leicht abschälen läßt (Schälfestigkeit 0,7 N/cm). Weder die auf der geätzten noch die auf der aufgerauhten Folie befindliche Polyimidschicht ließ sich ohne Beschädigung der Polyimid-Folie abtrennen, um auf diese Weise die Schälfestigkeit zu messen. Nach einer siebentägigen Behandlung bei 260 °C wies der Polyimid-Film auf der gerauhten Folie eine ausgezeichnete Haftung und Geschmeidigkeit auf.

Andere Ausgangsverbindungen, die über die Zwischenstufe der Polyamidsäure Polyimide bilden können, führen zu analogen Ergebnissen, sofern das Polyimid in Phenolen oder anderen Polyimidisierungslösungsmitteln unlöslich ist. So ist es also möglich, diese Polyimide direkt mit einem Metallsubstrat in Form eines Laminates zu verbinden, indem man eine Polyamidsäurelösung — die Vorstufe eines Polyimides — extrudiert und die Polyamidsäure in situ zu einem unlöslichen, nicht mehr formbaren Polyimid kondensiert. Darüberhinaus ist es möglich, diese unlöslichen Polyimide auch mit anderen Substraten, wie den oben aufgeführten in Form eines Laminates zu verbinden.

Tabelle

| Eigenschaft (Polyimidschicht) | Beispiel 1 | Beispiel 2 | Prüfung |
|---|---|---|---|
| Durchschlagsfestigkeit, KV $10^{-3}$ inch bei 60 Hz | 4,4 | 4,35 | ASTM D-149 |
| Dielektrizitätskonstante bei 1 KHz und 25 °C | 4,0 | 3,9 | ASTM D-150 |
| Dielektrischer Verlustfaktor bei 1 KHz und 25 °C | 0,0047 | 0,0039 | ASTM D-150 |
| Zugfestigkeit, $N/mm^2$ | 105 | 110 | ASTM D882 |
| Bruchdehnung, % | 45 | 31 | ASTM D882 |
| Dichte, $g/cm^3$ | 1,42 | 1,42 | ASTM D1505 |
| Dicke, µm | 66 | 61 | ASTM D374 |
| LOI | 40 | 40 | ASTM D2863 |
| **Eigenschaft (Laminat)** | | | |
| Schälfestigkeit, N/cm | 8,2 | 4,8 | IPC TM 650 2.4.9 |
| Verhalten beim Löten ohne weitere Vorbehandlung | keine Blasenbildung kein Ablösen | keine Blasenbildung kein Ablösen | IPC TM 650 2.4.13 (leicht modifiziert) |

**Patentansprüche**

1. Flexibles Laminat bestehend aus einer nicht mehr formbaren Schicht aus einem vollaromatischen Polyimid und einem Trägermaterial, dadurch gekennzeichnet, daß die Polyimidschicht direkt an dem Trägermaterial mit einer Schälfestigkeit von mindestens 4,0 N/cm haftet, wobei das Polyimid in phenolischen Lösungsmitteln unlöslich ist und die Polyimidschicht eine Zugfestigkeit von 100 bis 150 $N/mm^2$, eine Bruchdehnung von 15 bis 100 % und einen dielektrischen Verlustfaktor von $1{,}5 \times 10^{-3}$ bis $5 \times 10^{-3}$ bei 1 KHz aufweist.

2. Laminat nach Anspruch 1, dadurch gekennzeichnet, daß die Dicke der Polyimidschicht 10 µm bis 1 mm beträgt.

3. Laminat nach den Ansprüchen 1 bis 2, dadurch gekennzeichnet, daß die Dicke der Polyimidschicht 50 bis 250 µm beträgt.

4. Laminat nach den Ansprüchen 1 bis 2, dadurch gekennzeichnet, daß die Dicke der Polyimidschicht 30 bis 250 µm beträgt.

5. Laminat nach den Ansprüchen 1 bis 4, dadurch gekennzeichnet, daß das Polyimid die folgende sich wiederholende Struktur aufweist.

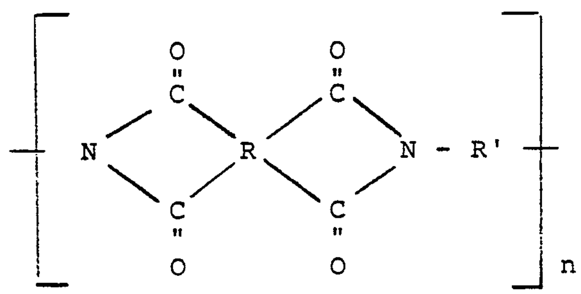

wobei
R ein vierwertiger aromatischer Rest
R' ein zweiwertiger aromatischer Rest
ist.

6. Laminat nach Anspruch 5, dadurch gekennzeichnet, daß

R 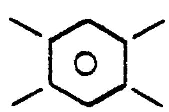 und R' 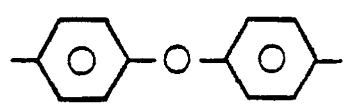

darstellen.

7. Laminat nach den Ansprüchen 1 bis 6, dadurch gekennzeichnet, daß das Polyimid gebildet wird durch thermische Cyclisierung einer durch Umsetzung von Pyromellitsäure-di-anhydrid (PMDA) mit 4,4'-Diaminodiphenyläther (DADE) in Anwesenheit eines organischen polaren Lösungsmittels erhaltenen Polyamidsäure, wobei das Molverhältnis von PMDA zu DADE im Bereich von 0,95 bis 1,05 liegt, wobei das Laminat dadurch erhalten worden ist, daß man mit einem kontinuerlichen Verfahren eine Lösung der Polyamidsäure, die mindestens 50 Gew.-% des Lösungsmittels enthält, ohne vorherige Entfernung von wesentlichen Mengen des Lösungsmittels auf das Trägermaterial aufbringt, anschließend stufenweise das Lösungsmittel in situ bei einer Temperatur im Bereich von 100 bis 200 °C entfernt und die gebildete Folie in situ bei einer höheren Temperatur zu dem Polyimid aushärtet.

8. Laminat nach Anspruch 7, dadurch gekennzeichnet, daß die Polyamidsäurelösung durch Reaktion in einem Extruder erhalten worden ist.

9. Laminat nach Anspruch 7 oder 8, dadurch gekennzeichnet, daß die Polyamidsäurelösung durch Rakeln auf das Trägermaterial aufgebracht worden ist.

10. Laminat nach Anspruch 7 oder 8, dadurch gekennzeichnet, daß die Polyamidsäurelösung durch Extrudieren auf das Trägermaterial verformt aufgebracht worden ist.

11. Laminat nach den Ansprüchen 7 bis 10, dadurch gekennzeichnet, daß das polare organische Lösungsmittel ein aprotisches Lösungsmittel ist.

12. Laminat nach Anspruch 11, dadurch gekennzeichnet, daß das aprotische polare organische Lösungsmittel Dimethylacetamid, Dimethylformamid, N-Methyl-2-pyrrolidon und/oder Dimethylsulfoxid ist.

13. Laminat nach den Ansprüchen 1 bis 12, dadurch gekennzeichnet, daß als Trägermaterial Drähte aus metallischen Werkstoffen und/oder Kabel aus metallischen Werkstoffen eingesetzt werden.

14. Laminat nach den Ansprüchen 1 bis 12, dadurch gekennzeichnet, daß als Trägermaterial Folien aus metallischen Werkstoffen eingesetzt werden.

15. Laminat nach Anspruch 14, dadurch gekennzeichnet, daß Folien aus Kupfer, Aluminium, Nickel oder Stahl eingesetzt werden.

16. Laminat nach Anspruch 15, dadurch gekennzeichnet, daß das Trägermaterial gewalztes getempertes Kupfer ist.

17. Laminat nach Anspruch 13 bis 14, dadurch gekennzeichnet, daß das Trägermaterial eine Metallegierung ist.

18. Laminat nach Anspruch 17, dadurch gekennzeichnet, daß das Trägermaterial eine Nickel-Chrom-Eisen-Legierung ist.

19. Laminat nach Anspruch 17, dadurch gekennzeichnet, daß das Trägermaterial eine Kupfer-Nickel-Legierung ist.

20. Laminat nach Anspruch 17, dadurch gekennzeichnet, daß das Trägermaterial eine Oberfläche mit einem Mittenrauhwert von mindestens 0,20 µm hat.

21. Laminat nach Anspruch 1 bis 20, dadurch gekennzeichnet, daß die Schälfestigkeit des Laminates bei über 5,0 N/cm liegt.

22. Verfahren zur Herstellung eines Laminates aus einem vollaromatischen nicht mehr formbaren Polyimid und einem Trägermaterial durch Aufbringen einer Polyamidsäurelösung, die aus einer aromatischen Tetracarbonsäure oder deren Dianhydrid und einem primären aromatischen Diamin gebildet wird, auf ein Trägermaterial ohne Zwischenschicht und Erhitzen des beschichteten Trägermaterials, dadurch gekennzeichnet, daß man die aromatische Tetracarbonsäure oder deren Dianhydrid mit dem aromatischen Diamin im Molverhältnis von 0,95 : 1 bis 1,05 : 1 in einem polaren Lösungsmittel zu einer Polymerverbindung aus einer Polyamidsäure mit der Formel

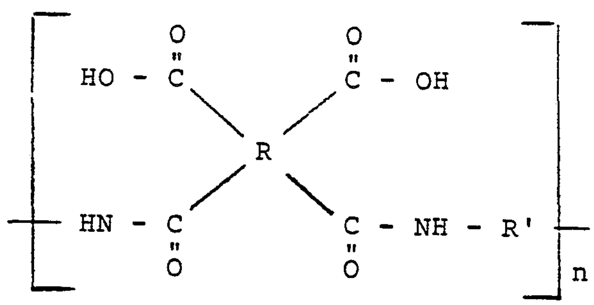

wobei

R einen aromatischen vierwertigen Rest und

R′ einen zweiwertigen aromatischen Rest darstellen und

n ausreicht, um eine Polyamidsäure mit einem $\eta_{red}$-Wert von mindestens 0,5 zu erhalten, umsetzt, aus der erhaltenen Polyamidsäurelösung auf dem Trägermaterial das Lösungsmittel in einer ersten Stufe, deren Temperatur im Bereich von 100 bis 200 °C liegt, in situ entfernt, wobei im wesentlichen die gesamte Lösungsmittelmenge entfernt wird, und den Film in einer zweiten Stufe, bei der die Temperatur mehr als 200 °C, vorzugsweise mehr als 300 °C beträgt, in situ zu einem in phenolischen Lösungsmitteln unlöslichen, nicht mehr formbaren Polyimid aushärtet, wobei mindestens 95 % der Polyamidsäure zu Polyimid umgesetzt werden.

23. Verfahren nach Anspruch 22, dadurch gekennzeichnet, daß man das mit der Polyamidsäurelösung beschichtete Trägermaterial kontinuierlich durch mindestens zwei Heizzonen mit steigender Temperatur laufen läßt.

24. Verfahren nach den Ansprüchen 22 bis 23, dadurch gekennzeichnet, daß die Umsetzung der aromatischen Tetracarbonsäure oder ihres Dianhydrids mit dem aromatischen Diamin zur Polyamidsäurelösung in einem Extruder durchgeführt wird.

25. Verfahren nach den Ansprüchen 22 bis 24, dadurch gekennzeichnet, daß die Polyamidsäurelösung von einer Misch- und Fördervorrichtung kontinuierlich dosiert und durch eine geformte Öffnung auf das Trägermaterial extrudiert wird.

26. Verfahren nach den Ansprüchen 22 bis 24, dadurch gekennzeichnet, daß die Polyamidsäurelösung durch Rakeln auf das Trägermaterial aufgebracht wird.

27. Verfahren nach den Ansprüchen 22 bis 26, dadurch gekennzeichnet, daß das Trägermaterial ein metallischer Werkstoff ist.

28. Verfahren nach den Ansprüchen 22 bis 27, dadurch gekennzeichnet, daß das Trägermaterial ein Draht oder ein Kabel ist.

29. Verfahren nach den Ansprüchen 22 bis 27, dadurch gekennzeichnet, daß das Trägermaterial eine Folie ist.

30. Verfahren nach den Ansprüchen 27 bis 29, dadurch gekennzeichnet, daß das Trägermaterial aus Kupfer, Aluminium, Nickel oder Stahl besteht.

31. Verfahren nach den Ansprüchen 27 bis 29, dadurch gekennzeichnet, daß das Trägermaterial eine Metallegierung ist.

32. Verfahren nach Anspruch 31, dadurch gekennzeichnet, daß das Trägermaterial eine Nickel-Chrom-Eisen-Legierung ist.

33. Verfahren nach Anspruch 31, dadurch gekennzeichnet, daß das Trägermaterial eine Kupfer-Nickel-Legierung ist.

34. Verfahren nach den Ansprüchen 22 bis 33, dadurch gekennzeichnet, daß die mit der Polyamidsäurelösung zu beschichtende Oberfläche des Trägermaterials vorher mittels mechanischer und/oder chemischer Behandlung aufgerauht bzw. geätzt wurde.

35. Verfahren nach Anspruch 34, dadurch gekennzeichnet, daß die chemische und/oder mechanische Vorbehandlung so durchgeführt wird, daß die zu beschichtende Oberfläche des Trägermaterials nach der Vorbehandlung einen Mittenrauhwert von mindestens 0.20 µm hat.

36. Verfahren nach den Ansprüchen 22 bis 35, dadurch gekennzeichnet, daß der Film in der zweiten Zone auf eine Temperatur im Bereich von 300-600 °C erhitzt wird.

37. Verfahren nach den Ansprüchen 22 bis 36, dadurch gekennzeichnet, daß das polare Lösungsmittel ein polares aprotisches Lösungsmittel ist.

38. Verfahren nach Anspruch 37, dadurch gekennzeichnet, daß das Lösungsmittel Dimethylacetamid, Dimethylformamid, N-Methyl-2-pyrrolidon und/oder Dimethylsulfoxid ist.

## Claims

1. A flexible laminate consisting of a no longer formable layer of a fully aromatic polyimide and a support material, characterized in that the polyimide layer adheres directly to the support material with a peel strength of at least 4.0 N/cm, the polyimide being insoluble in phenolic solvents and the polyimide layer having a tensile strength of from 100 to 150 N/mm², a breaking elongation of from 15 to 100 % and a dielectric dissipation factor of from $1.5 \times 10^{-3}$ to $5 \times 10^{-3}$ at 1 KHz.

2. A laminate as claimed in Claim 1, characterized in that the polyimide layer is from 10 µm to 1 mm thick.

3. A laminate as claimed in Claims 1 and 2, characterized in that the polyimide layer is from 50 to 250 µm thick.

4. A laminate as claimed in Claims 1 and 2, characterized in that the polyimide layer is from 30 to 250 µm thick.

5. A laminate as claimed in Claims 1 to 4, characterized in that the polyimide has the following recurring structure :

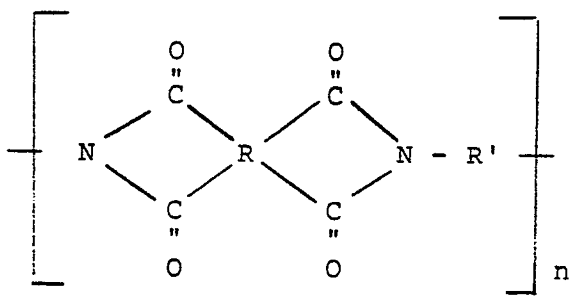

in which

R is a tetrafunctional aromatic radical and

R' is a difunctional aromatic radical.

6. A laminate as claimed in Claim 5, characterized in that

R 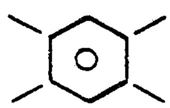 and R' 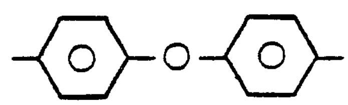

R represents and R' represents

7. A laminate as claimed in Claims 1 to 6, characterized in that the polyimide is formed by thermal cyclization of a polyamide acid obtained by reaction of pyromellitic acid dianhydride (PMDA) with 4,4'-diaminodiphenylether (DADE) in the presence of an organic polar solvent, the molar ration of PMDA to DADE being from 0.95 to 1.05, the laminate having been obtained by continuous application of a solution of the polyamide acid containing at least 50 % by weight of the solvent to the support material without removal of significant quantities of the solvent beforehand, subsequent removal of the solvent in stages in situ at a temperature of from 100 to 200 °C and hardening of the film formed in situ at a higher temperature to form the polyimide.

8. A laminate as claimed in Claim 7, characterized in that the polyamide acid solution is obtained by reaction in an extruder.

9. A laminate as claimed in Claim 7 or 8, characterized in that the polyamide acid solution is applied to the support material by knife coating.

10. A laminate as claimed in Claim 7 or 8, characterized in that the polyamide acid solution is applied to the support material in shaped form by extrusion.

11. A laminate as claimed in Claims 7 to 10, characterized in that the polar organic solvent is an aprotic solvent.

12. A laminate as claimed in Claim 11, characterized in that the aprotic polar organic solvent is dimethyl acetamide, dimethyl formamide, N-methyl-2-pyrrolidone and/or dimethyl sulfoxide.

13. A laminate as claimed in Claims 1 to 12, characterized in that wires of metallic materials and/or cables of metallic materials are used as the support material.

14. A laminate as claimed in Claims 1 to 12, characterized in that foils of metallic materials are used as the support material.

15. A laminate as claimed in Claim 14, characterized in that foils of copper, aluminium, nickel or steel are used.

16. A laminate as claimed in Claim 15, characterized in that rolled tempered copper is used as the support material.

17. A laminate as claimed in Claims 13 and 14, characterized in that a metal alloy is used as the support material.

18. A laminate as claimed in Claim 17, characterized in that the support material is a nickel-chromium-iron alloy.

19. A laminate as claimed in Claim 17, characterized in that the support material is a copper-nickel alloy.

20. A laminate as claimed in Claim 17, characterized in that the support material has a surface with a center line average of at least 0.20 μm.

21. A laminate as claimed in Claims 1 to 20, characterized in that the peel strength of the laminate is above 5.0 N/cm.

22. A process for the production of a laminate from a fully aromatic, no longer formable polyimide and a support material by application of a polyamide acid solution formed from an aromatic tetracarboxylic acid or a dianhydride thereof and a primary aromatic diamine to a support material without an intermediate layer and heating of the coated support material, characterized in that the aromatic tetracarboxylic acid or an anhydride thereof is reacted with the aromatic diamine in a molar ratio of from 0.95 : 1 to 1.05 : 1 in a polar solvent to form a polymer compound of a polyamide acid corresponding to the following formula

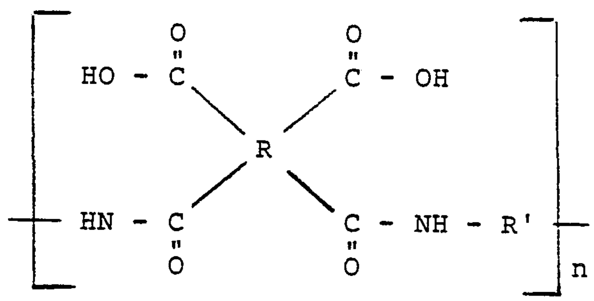

in which

R is an aromatic tetrafunctional radical and

R' is a difunctional aromatic radical and

n is sufficient to obtain a polyamide acid having an $\eta_{red}$ value of at least 0.5, the solvent is removed from the polyamide acid solution obtained on the support material in situ in a first stage at a temperature of from 100 to 200 °C, substantially the entire quantity of solvent being removed, and the film is hardened in situ in a second stage, in which the temperature is above 200 °C and preferably above 300 °C, to give a no longer formable polyimide insoluble in phenolic solvents, at least 95 % of the polyamide acid being reacted to polyimide.

23. A process as claimed in Claim 22, characterized in that the support material coated with the polyamide acid solution is allowed to pass continuously through at least two heating zones with increasing temperature.

24. A process as claimed in Claims 22 to 23, characterized in that the reaction of the aromatic tetracarboxylic acid or anhydride with the aromatic diamine to the polyamide acid solution is carried out in an extruder.

25. A process as claimed in Claims 22 to 24, characterized in that the polyamide acid solution is continuously fed by a combined mixer and feeder and extruded through a shaped opening onto the support material.

26. A process as claimed in Claims 22 to 24, characterized in that the polyamide acid solution is applied to the support material by knife coating.

27. A process as claimed in Claims 22 to 26, characterized in that the support material is a metallic material.

28. A process as claimed in Claims 22 to 27, characterized in that the support material is a wire or a cable.

29. A process as claimed in Claims 22 to 27, characterized in that the support material is a foil.

30. A process as claimed in Claims 27 to 29, characterized in that the support material consists of copper, aluminium, nickel or steel.

31. A process as claimed in Claims 27 to 29, characterized in that the support material is a metal alloy.

32. A process as claimed in Claim 31, characterized in that the support material is a nickel-chromium-iron alloy.

33. A process as claimed in Claim 31, characterized in that the support material is a copper-nickel alloy.

34. A process as claimed in Claims 22 to 23, characterized in that the surface of the support material to be coated with the polyamide acid solution is roughened or etched beforehand by mechanical and/or chemical treatment.

35. A process as claimed in Claim 34, characterized in that the chemical and/or mechanical pretreatment is carried out in such a way that, after the pretreatment, the surface of the support material to be coated has a center line average of at least 0.20 μm.

36. A process as claimed in Claims 22 to 35, characterized in that, in the second zone, the film is heated to a temperature of from 300 to 600 °C.

37. A process as claimed in Claims 22 to 36, characterized in that the polar solvent is a polar aprotic solvent.

38. A process as claimed in Claim 37, characterized in that the solvent is dimethyl acetamide, dimethyl formamide, N-methyl-2-pyrrolidone and/or dimethyl sulfoxide.

**Revendications**

1. Stratifié souple constitué d'une couche, qui n'est plus déformable, d'un polyimide entièrement aromatique et d'une matière de support, caractérisé en ce que la couche de polyimide adhère directement à la matière de support avec une résistance à l'arrachement d'au moins 4,0 N/cm, le polyimide étant insoluble dans les solvants phénoliques et la couche de polyimide présentant une résistance à la traction de 100 à 150 $N/mm^2$, un allongement à la rupture de 15 à 100 % et un facteur de perte diélectrique de $1,5 \times 10^{-3}$ à $5 \times 10^{-3}$ à 1 KHz.

2. Stratifié selon la revendication 1, caractérisé en ce que l'épaisseur de la couche de polyimide est de 10 microns à 1 mm.

3. Stratifié selon les revendications 1 et 2, caractérisé en ce que l'épaisseur de la couche de polyimide est de 50 à 250 microns.

4. Stratifié selon les revendications 1 et 2, caractérisé en ce que l'épaisseur de la couche de polyimide est de 30 à 250 microns.

5. Stratifié selon les revendications 1 à 4, caractérisé en ce que le polyimide présente le motif suivant :

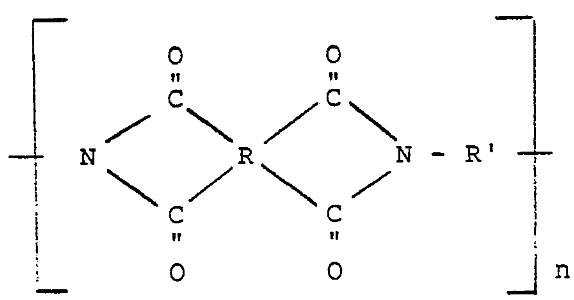

dans lequel

R est un radical aromatique tétravalent, et

R' est un radical aromatique divalent.

6. Stratifié selon la revendication 5, caractérisé en ce que R représente

R 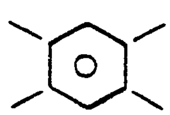 et R' 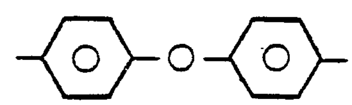

7. Stratifié selon les revendications 1 à 6, caractérisé en ce que le polyimide est formé par cyclisation thermique d'un polyamide-acide obtenu par réaction du dianhydride pyromellitique (PMDA) avec l'éther 4,4'-diaminodiphénylique (DADE) en présence d'un solvant polaire organique, le rapport molaire du PMDA au DADE étant situé dans le domaine allant de 0,95 à 1,05, le stratifié étant obtenu par application sur la matière de support, par un procédé continu, d'une solution du polyamide-acide qui contient au moins 50 % en poids du solvant, sans élimination préalable de quantités importantes du solvant, puis par élimination progressive du solvant in situ, à une température située dans le domaine allant de 100 à 200 °C, et par durcissement de la feuille formée, in situ, à une température plus élevée, en le polyimide.

8. Stratifié selon la revendication 7, caractérisé en ce que la solution de polyamide-acide a été obtenue par réaction dans une extrudeuse.

9. Stratifié selon la revendication 7 ou 8, caractérisé en ce que la solution de polyamide-acide a été appliquée sur la matière de support par dépôt avec une râcle.

10. Stratifié selon la revendication 7 ou 8, caractérisé en ce que la solution de polyamide-acide a été appliquée par extrusion sur la matière de support, à l'état déformé.

11. Stratifié selon les revendications 7 à 10, caractérisé en ce que le solvant organique polaire est un solvant aprotique.

12. Stratifié selon la revendication 11, caractérisé en ce que le solvant organique polaire aprotique est le diméthylacétamide, le diméthylformamide, la N-méthyl-2-pyrrolidone et/ou le diméthylsulfoxyde.

13. Stratifié selon les revendications 1 à 12, caractérisé en ce que l'on utilise comme matière de support des fils de matériaux métalliques et/ou des câbles de matériaux métalliques.

14. Stratifié selon les revendications 1 à 12, caractérisé en ce qu'on utilise comme matière de support des feuilles de matériaux métalliques.

15. Stratifié selon la revendication 14, caractérisé en ce qu'on utilise des feuilles de cuivre, d'aluminium, de nickel ou d'acier.

16. Stratifié selon la revendication 15, caractérisé en ce que la matière de support est du cuivre laminé recuit.

17. Stratifié selon les revendications 13 à 14, caractérisé en ce que la matière de support est un alliage métallique.

18. Stratifié selon la revendication 17, caractérisé en ce que la matière de support est un alliage nickel-chrome-fer.

19. Stratifié selon la revendication 17, caractérisé en ce que la matière de support est un alliage cuivre-nickel.

20. Stratifié selon la revendication 17, caractérisé en ce que la matière de support a une surface dont la rugosité moyenne est d'au moins 0,20 micron.

21. Stratifié selon les revendications 1 à 20, caractérisé en ce que la résistance du stratifié à la déstratification est supérieure à 5,0 N/cm.

22. Procédé de fabrication d'un stratifié d'un polyimide entièrement aromatique, qui n'est plus déformable, et d'une matière de support, par application d'une solution de polyamide-acide, qui est formé à partir d'un acide tétracarboxylique aromatique ou de son dianhydride et d'une diamine aromatique primaire, sur une matière de support, sans couche intermédiaire, et chauffage de la matière de support enduite, caractérisé en ce qu'on fait réagir l'acide tétracarboxylique aromatique ou son dianhydride avec la diamine aromatique dans un rapport molaire de 0,95 : 1 à 1,05 : 1, dans un solvant polaire, pour obtenir un composé polymère polyamide-acide répondant à la formule

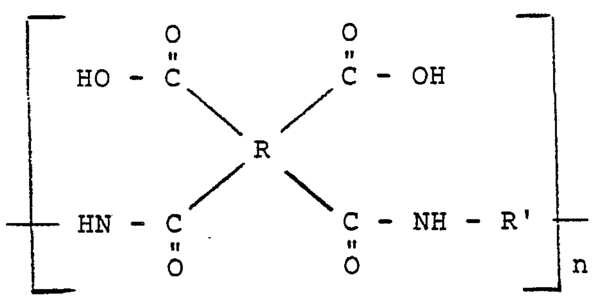

dans laquelle

R désigne un radical tétravalent aromatique,

R' désigne un radical divalent aromatique et

n a une valeur suffisante pour que l'on obtienne un polyamide-acide ayant une valeur de $\eta_{red}$ d'au moins 0,5, en ce qu'on élimine in situ le solvant de la solution de polyamide-acide obtenue sur la matière de support, dans une première étape à une température située dans le domaine allant de 100 à 200 °C, la quasi-totalité du solvant étant éliminée, et en ce qu'on durcit in situ la pellicule dans une seconde étape, à une température dépassant 200 °C, de préférence dépassant 300 °C, pour obtenir un polyimide insoluble dans les solvants phénoliques et qui n'est plus déformable, au moins 95 % du polyamide-acide étant transformé en polyimide.

23. Procédé selon la revendication 22, caractérisé en ce qu'on fait passer en continu la matière de support enduite de la solution de polyamide-acide à travers au moins deux zones de chauffage à température croissante.

24. Procédé selon les revendications 22 à 23, caractérisé en ce que la réaction de l'acide tétracarboxylique aromatique ou de son dianhydride avec la diamine aromatique, qui donne une solution de polyamide-acide, est effectuée dans une extrudeuse.

25. Procédé selon les revendications 22 à 24, caractérisé en ce que la solution de polyamide-acide est introduite en continu et de façon contrôlée par un dispositif de mélange et d'alimentation, et extrudée

à travers une ouverture de forme appropriée sur la matière de support.

26. Procédé selon les revendications 22 à 24, caractérisé en ce que la solution de polyamide-acide est appliquée par râclage sur la matière de support.

27. Procédé selon les revendications 22 à 26, caractérisé en ce que la matière de support est un matériau métallique.

28. Procédé selon les revendications 22 à 27, caractérisé en ce que la matière de support est un fil ou un câble.

29. Procédé selon les revendications 22 à 27, caractérisé en ce que la matière de support est une feuille.

30. Procédé selon les revendications 27 à 29, caractérisé en ce que la matière de support est constituée de cuivre, d'aluminium, de nickel ou d'acier.

31. Procédé selon les revendications 27 à 29, caractérisé en ce que la matière de support est un alliage métallique.

32. Procédé selon la revendication 31, caractérisé en ce que la matière de support est un alliage nickel-chrome-fer.

33. Procédé selon la revendication 31, caractérisé en ce que la matière de support est un alliage cuivre-nickel.

34. Procédé selon les revendications 22 à 23, caractérisé en ce que la surface de la matière de support à enduire avec la solution de polyamide-acide a été dépolie ou décapée au préalable au moyen d'un traitement mécanique et/ou chimique.

35. Procédé selon la revendication 34, caractérisé en ce que le prétraitement chimique et/ou mécanique est effectué de telle manière que la surface de la matière de support à enduire possède après le prétraitement, une rugosité moyenne d'au moins 0,20 micron.

36. Procédé selon les revendications 22 à 35, caractérisé en ce que le film est chauffé dans la seconde zone à une température située dans le domaine allant de 300 à 600 °C.

37. Procédé selon les revendications 22 à 36, caractérisé en ce que le solvant polaire est un solvant polaire aprotique.

38. Procédé selon la revendication 37, caractérisé en ce que le solvant est le diméthylacétamide, le diméthylformamide, la N-méthyl-2-pyrrolidone et/ou le diméthylsulfoxyde.

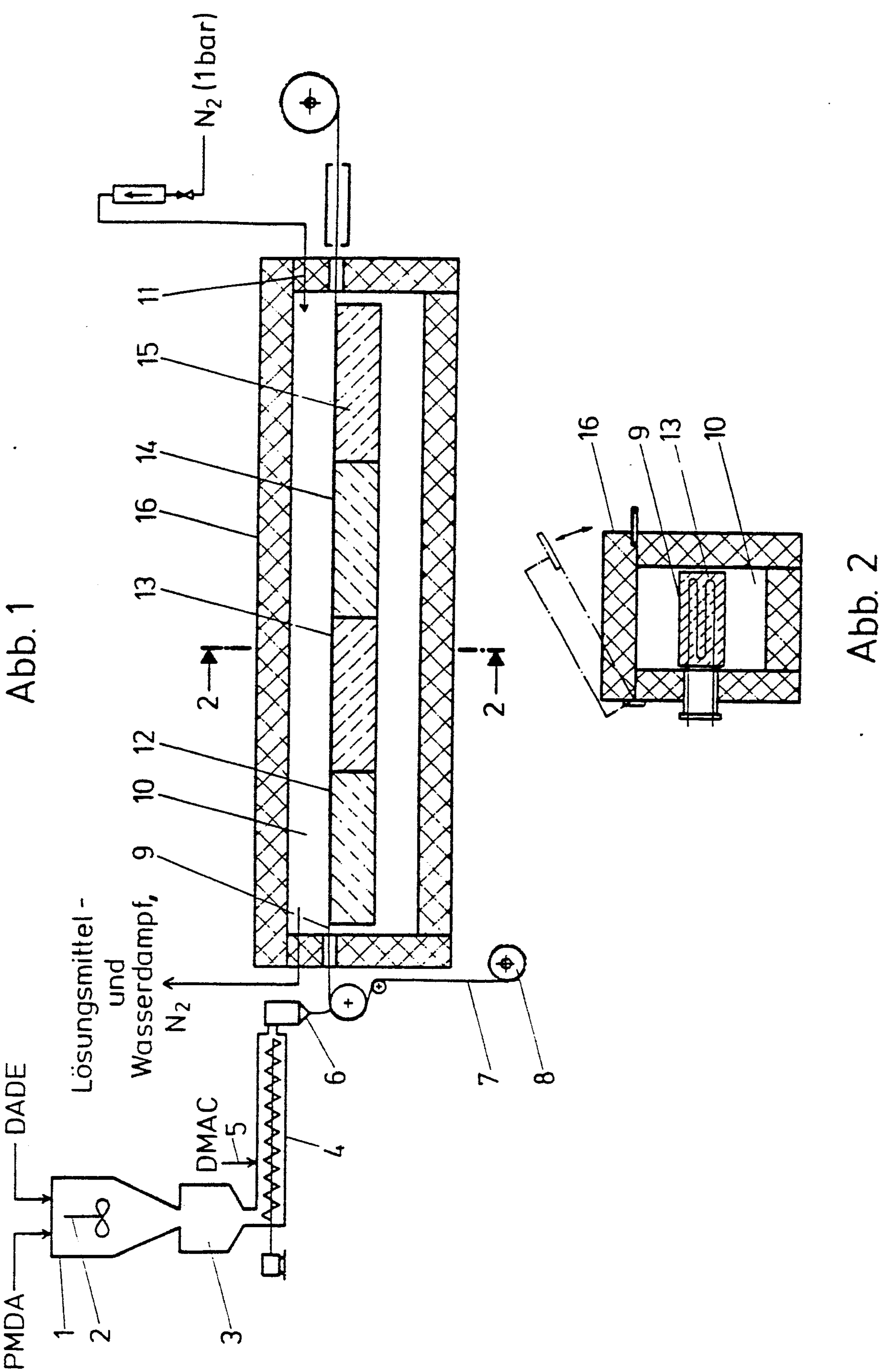
N2 (1 bar)
11
15
14
16
13
12
10
9
2
2
Lösungsmittel- und Wasserdampf, N2
PMDA
DADE
DMAC
1
2
3
4
5
6
7
8
16
9
13
10

Abb. 1

Abb. 2